# EUROPEAN PATENT APPLICATION

(11) **EP 2 899 244 A1**
(43) Date of publication of application: **29.07.2015**
(21) Application number: 13839161.0
(22) Date of filing: 17.09.2013
(51) Int. Cl.: C09J 9/02, H01L 21/60, H01L 23/36, H01L 33/00, H05K 7/20

(54) **ANISOTROPIC CONDUCTIVE ADHESIVE AND CONNECTION STRUCTURE**

(30) Priority: 24.09.2012 JP 2012210223
(71) Applicant: Dexerials Corporation, Tokyo 141-0032 (JP)
(72) Inventor: NAMIKI, Hidetsugu, Tokyo 141-0032 (JP); KANISAWA, Shiyuki, Tokyo 141-0032 (JP); ISHIGAMI, Akira, Tokyo 141-0032 (JP)
(74) Representative: Witte, Weller & Partner Patentanwälte mbB
(86) International application number: PCT/JP2013/075038
(87) International publication number: WO 2014/046088

(57) **Abstract**

An anisotropic conductive adhesive includes: a conductive particle including a resin particle and a conductive metal layer that is formed on a surface of the resin particle; a thermally conductive particle that is a metal particle or an insulation coated particle, wherein the metal particle has an average particle size that is smaller than an average particle size of the conductive particle, and the insulation coated particle has an average particle size that is smaller than the average particle size of the conductive particle and includes a metal particle and an insulating layer that is formed on a surface of the metal particle; and an adhesive component in which the conductive particle and the thermally conductive particle are dispersed.

## Description

### TECHNICAL FIELD

The technology relates to an anisotropic conductive adhesive in which conductive particles are dispersed and to a connection structure using the same. In particular, the technology relates to an anisotropic conductive adhesive capable of radiating heat generated by a chip (device) such as a driver IC (Integrated Circuit) and LED (Light Emitting Diode), and to a connection structure using the same.

### BACKGROUND ART

A wire bonding method has been used as a method of mounting an LED device on a substrate. In addition thereto, a method in which a conductive paste is used has been proposed as a method that uses no wire bond. A method has been also proposed in which an anisotropic conductive adhesive is used as a method that uses no conductive paste.

Also, with the development of an LED device directed to flip-chip (FC: Flip-Chip) mounting, gold-tin eutectic bonding has been used as a method of mounting, on a substrate, the LED device for the FC mounting. In addition thereto, a solder connection method in which a solder paste is used has been proposed as a method that uses no gold-tin eutectic. A method has been also proposed in which an anisotropic conductive adhesive is used as a method that uses no solder paste.

### PRIOR ART DOCUMENT

### PATENT DOCUMENT

Patent Document 1: Japanese Unexamined Patent Application Publication No. 2005-108635
Patent Document 2: Japanese Unexamined Patent Application Publication No. 2009-283438
Patent Document 3: Japanese Unexamined Patent Application Publication No. 2008-041706
Patent Document 4: Japanese Unexamined Patent Application Publication No. 2007-023221

### SUMMARY OF THE INVENTION

However, a thermal conductivity of a cured product of an anisotropic conductive adhesive is about 0.2 W/(m·K), preventing sufficient transfer of heat generated by an LED device to a substrate from being occurred. Also, in FC mounting that uses the anisotropic conductive adhesive, only the conductive particles in an electric connection region serve as a heat radiating path, leading to deterioration in a heat radiation property.

It is therefore desirable to provide an anisotropic conductive adhesive and a connection structure capable of achieving a high heat radiation property.

In the technology, it was found that mixing of a conductive particle in which a conductive metal layer is formed on a surface of a resin particle and a thermally conductive particle whose average particle size is smaller than an average particle size of the conductive particle achieved an above-described object.

More specifically, an anisotropic conductive adhesive according to an embodiment of the technology includes: a conductive particle including a resin particle and a conductive metal layer that is formed on a surface of the resin particle; a thermally conductive particle that is a metal particle or an insulation coated particle, wherein the metal particle has an average particle size that is smaller than an average particle size of the conductive particle, and the insulation coated particle has an average particle size that is smaller than the average particle size of the conductive particle and includes a metal particle and an insulating layer that is formed on a surface of the metal particle; and an adhesive component in which the conductive particle and the thermally conductive particle are dispersed.

Also, a connection structure according to an embodiment of the technology includes: a terminal of a first electronic component; a terminal of a second electronic component; a conductive particle provided between the terminal of the first electronic component and the terminal of the second electronic component and electrically connecting the terminal of the first electronic component with the terminal of the second electronic component, wherein the conductive particle includes a resin particle and a conductive metal layer that is formed on a surface of the resin particle; and a thermally conductive particle provided and held between the terminal of the first electronic component and the terminal of the second electronic component, wherein the thermally conductive particle is a metal particle or an insulation coated particle, the metal particle has an average particle size that is smaller than an average particle size of the conductive particle, and the insulation coated particle has an average particle size that is smaller than the average particle size of the conductive particle and includes a metal particle and an insulating layer that is formed on a surface of the metal particle.

In the anisotropic conductive adhesive or the connection structure according to an embodiment of the technology, the conductive particle is deformed to be flat by pressing and the thermally conductive particle is crushed upon pressure bonding to increase contact area between opposing terminals. Hence, it is possible to achieve a high heat radiation property.

### BRIEF DESCRIPTION OF THE DRAWINGS

[FIG. 1] FIG. 1 is a cross-sectional view schematically illustrating a region between opposing terminals before pressure bonding.
[FIG. 2] FIG. 2 is a cross-sectional view schematically illustrating the region between the opposing terminals after the pressure bonding.
[FIG. 3] FIG. 3 is a cross-sectional view illustrating an example of an LED package according to an embodiment of the technology.
[FIG. 4] FIG. 4 is a cross-sectional view illustrating an example of an LED package according to another embodiment of the technology.
[FIG. 5] FIG. 5 is a cross-sectional view illustrating an example of an LED package based on a wire bonding method.
[FIG. 6] FIG. 6 is a cross-sectional view illustrating an example of an LED package in which a conductive paste is used.
[FIG. 7] FIG. 7 is a cross-sectional view illustrating an example of an LED package in which an anisotropic conductive adhesive is used.
[FIG. 8] FIG. 8 is a cross-sectional view illustrating an example of an LED package in which an LED device for FC mounting is mounted using gold-tin eutectic bonding.
[FIG. 9] FIG. 9 is a cross-sectional view illustrating an example of the LED package in which the LED device for FC mounting is mounted using the conductive paste.
[FIG. 10] FIG. 10 is a cross-sectional view illustrating an example of the LED package in which the LED device for FC mounting is mounted using the anisotropic conductive adhesive.

### DESCRIPTION OF EMBODIMENTS

In the following, an embodiment of the technology is described in detail in the following order, with reference to the drawings.
1. Anisotropic Conductive Adhesive and Manufacturing Method Thereof
2. Connection Structure and Manufacturing Method Thereof
3. Examples

### <1. Anisotropic Conductive Adhesive and Manufacturing Method Thereof>

In an anisotropic conductive adhesive according to an embodiment of the technology, a conductive particle in which a conductive metal layer is formed on a surface of a resin particle and a thermally conductive particle whose average particle size is smaller than an average particle size of the conductive particle are dispersed in a binder (adhesive component). The anisotropic conductive adhesive may be in a form of a paste, a film, or the like, which may be selected on an as-needed basis depending on purpose.

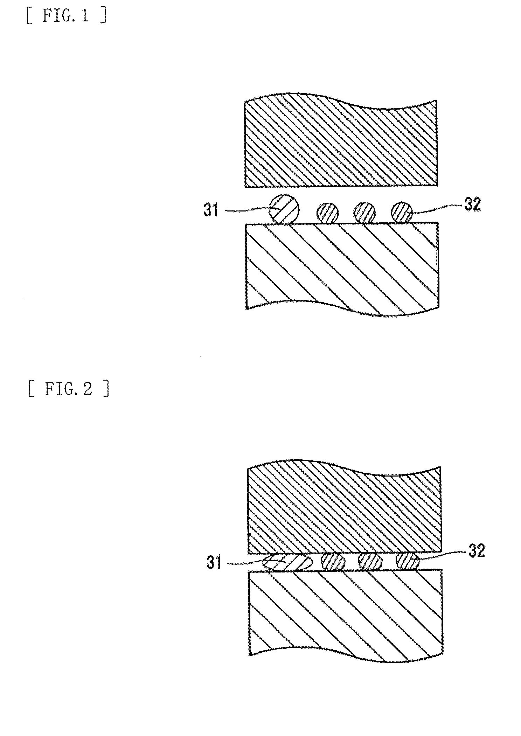

FIG. 1 is a cross-sectional view schematically illustrating a region between opposing terminals before pressure bonding, and FIG. 2 is a cross-sectional view schematically illustrating the region after the pressure bonding. In an embodiment of the technology, the anisotropic conductive adhesive has a configuration to be described later, thus making it possible to cause conductive particles 31 and thermally conductive particles 32 to be present between the terminals before the pressure bonding. In addition, the conductive particle 31 in which a resin particle is used for a core is deformed to be flat by pressing upon pressure bonding and thus causes elastic repulsion to the deformation, thereby making it possible to maintain a state in which electrical connection is established. Also, the thermally conductive particle 32 is crushed with the flat deformation of the conductive particle upon the pressure bonding and thus increases area brought into contact with the terminals, thereby making it possible to improve a heat radiation property. Also, when an insulation coated particle in which an insulating layer is formed on a surface of a metal particle high in thermal conductivity is used as the thermally conductive particle 32, the pressing breaks the insulating layer to allow the metal portion thereof to come into contact with the terminals, thereby making it possible to improve the heat radiation property as well as to achieve a superior property for withstand voltage.

The conductive particle may be a metal-coated resin particle in which a surface of a resin particle such as an epoxy resin, a phenol resin, an acrylic resin, an acrylonitrile-styrene (AS) resin, a benzoguanamine resin, a divinylbenzene-based resin, and a styrene-based resin is coated with a metal (conductive metal layer) such as Au, Ni, and Zn. The metal-coated resin particle is easy to crush and is thus deformed easily upon compression, thereby making it possible to increase contact area with respect to a wiring pattern and also to absorb variation in height of the wiring pattern.

The average particle size of the conductive particle may preferably be in a range from 1 µm to 10 µm, and more preferably be in a range from 2 µm to 6 µm. Also, a content of the conductive particle with respect to 100 parts.mass of the binder may preferably be in a range from 1 part.mass to 100 parts.mass in terms of connection reliability and insulation reliability.

The thermally conductive particle is a metal particle, or an insulation coated particle in which an insulating layer is formed on a surface of the metal particle. Also, the thermally conductive particle may have a shape of a grain, a scale, or the like, which may be selected on an as-needed basis depending on purpose.

The metal particle, or the metal particle of the insulation coated particle, may preferably have a thermal conductivity that is equal to or higher than 200 W/(m·K). The thermal conductivity of less than 200 W/(m·K) leads to a large thermal resistance value and deterioration in a heat radiation property. Examples of the metal particle, or the metal particle of the insulation coated particle, that has the thermal conductivity of 200 W/(m·K) or higher may include a metal simple substance such as Ag, Au, Cu, and Pt, and an alloy thereof. Among these, it is preferable that Ag or an alloy containing Ag as a major component be used in terms of a light extraction efficiency of LED and ease in being crushed upon pressure bonding.

A content of the metal particle may preferably be in a range from 5% by volume to 40% by volume both inclusive. When the content of the metal particle is excessively small, a superior heat radiation property may not be obtained, whereas connection reliability may not be obtained when the content is excessively large.

The insulating layer of the insulation coated particle may preferably be a resin such as a styrene resin, an epoxy resin, and an acrylic resin, or an inorganic material such as SiO₂, Al₂O₃, and TiO₂. A thickness of the insulating layer of the insulation coated particle may preferably be in a range from 10 nm to 1000 nm both inclusive, more preferably be in a range from 20 nm to 1000 nm both inclusive, and further preferably be in a range from 100 nm to 800 nm both inclusive. When the insulating layer is excessively thin, a superior property for withstand voltage may not be obtained, whereas a thermal resistance value of the connection structure may be increased when the insulating layer is excessively thick.

A content of the insulation coated particle may preferably be in a range from 5% by volume to 50% by volume both inclusive. When the content of the insulation coated particle is excessively small, a superior heat radiation property may not be obtained, whereas connection reliability may not be obtained when the content is excessively large.

The average particle size (D50) of the thermally conductive particle may preferably be 5% to 80% of the average particle size of the conductive particle. When the thermally conductive particle is excessively smaller than the conductive particle, the thermally conductive particle may not be captured between the opposing terminals upon the pressure bonding, and thereby a superior heat radiation property may not be obtained. On the other hand, when the thermally conductive particle is excessively larger than the conductive particle, the thermally conductive particle may not be filled at high density, and thereby a thermal conductivity of a cured product of the anisotropic conductive adhesive may not be improved.

The thermally conductive particle may preferably have an achromatic color of white or gray. This allows the thermally conductive particle to function as a light reflective particle, making it possible to obtain high luminance in application thereof to an LED device.

An adhesive composition used in an existing anisotropic conductive adhesive or an existing anisotropic conductive film may be utilized as a binder. Preferable examples of the adhesive composition may include an epoxy-curing-based adhesive containing, as a major component, an alicyclic epoxy compound, a heteroring-based epoxy compound, a hydrogenated epoxy compound, or the like.

Preferable examples of the alicyclic epoxy compound may include those that have two or more epoxy groups in a molecule. Such alicyclic epoxy compounds may be in a liquid state or a solid state. Specific examples thereof may include glycidyl hexahydro bisphenol A and 3,4-epoxycyclohexenyl methyl-3',4'-epoxycyclohexene carboxylate. Among these, 3,4-epoxycyclohexenyl methyl-3',4'-epoxycyclohexene carboxylate may preferably be used in terms of ensuring that a light transmission property suitable for mounting of the LED device is provided in the cured product, and in terms of a superior rapid curing property as well.

Examples of the heteroring epoxy compound may include epoxy compounds having a triazine ring. Particularly preferable examples thereof may include 1,3,5-tris(2,3-epoxypropyl)-1,3,5-triazine-2,4,6-(1H,3H,5H)-trione.

Usable examples of the hydrogenated epoxy compound may include hydrogen compounds of the above-mentioned alicyclic epoxy compounds or the heteroring-based epoxy compound, and other known hydrogenated epoxy resins.

The alicyclic epoxy compound, the heteroring-based epoxy compound, and the hydrogenated epoxy compound may be used alone or in combination of two or more kinds thereof. Also, other epoxy compounds may be used in combination in addition to these epoxy resin compounds as long as an effect of the technology is not impaired, examples of which may include: glycidyl ethers obtained by reaction of epichlorohydrin with polyhydric phenols such as bisphenol A, bisphenol F, bisphenol S, diaryl bisphenol A, hydroquinone, catechol, resorcine, cresol, tetrabromo bisphenol A, trihydroxy bephenyl, benzophenone, bisresorcinol, bisphenol hexafluoroacetone, tetramethyl bisphenol A, tetramethyl bisphenol F, tris(hydroxyphenyl)methane, bixylenol, phenolnovolak, and cresolnovolak; polyglycidyl ethers obtained by reaction of epichlorohydrin with aliphatic polyhydric alcohols such as glycerin, neopentylglycol, ethylene glycol, propylene glycol, hexylene glycol, polyethylene glycol, and polypropylene glycol; glycidyl ethers esters obtained by reaction of epichlorohydrin with hydroxycarboxylic acids such as p-oxybenzoic acid and β-oxynaphthoic acid; polyglycidyl esters obtained from polycarboxylic acids such as phthalic acid, methylphthalic acid, isophthalic acid, terephthalic acid, tetrahydrophthalic acid, endomethylene tetrahydrophthalic acid, endomethylene hexahydrophthalic acid, trimellitic acid, and polymerized aliphatic acid; glycidylaminoglycidyl ethers obtained from amino phenol or aminoalkyl phenol; glycidylaminoglycidyl esters obtained from aminobenzoic acid; glycidyl amines obtained from aniline, toluidine, tribromoaniline, xylylene diamine, diaminocyclohexane, bisaminomethyl cyclohexane, 4,4'-diaminodiphenyl methane, 4,4'-diaminodiphenyl sulfone, etc.; and known epoxy resins such as epoxidized polyolefins.

Examples of the curing agent may include acid anhydrides, imidazole compounds, and dicyanes. Among these, acid anhydrides that hardly cause discoloration of the cured products, such as alicyclic acid anhydride-based curing agents in particular, may preferably be used, a specific example of which may preferably be methylhexahydrophthalic anhydride, etc.

When the alicyclic epoxy compound and an alicyclic-acid-anhydride-based curing agent are used in the adhesive composition, the alicyclic-acid-anhydride-based curing agent may preferably be used in a proportion of 80 part.mass to 120 parts.mass, may more preferably be used in a proportion of 95 part.mass to 105 parts.mass, with respect to 100 parts.mass of the alicyclic epoxy compound, because excessively small added amount of the alicyclic-acid-anhydride-based curing agent results in a large number of uncured epoxy compounds, and excessively large used amount thereof tends to promote corrosion of a material of a member subjected to adhesion due to an influence of an redundant curing agent.

In the anisotropic conductive adhesive having such a configuration as described above, the conductive particle is deformed to be flat by the pressing and the thermally conductive particle is crushed upon the pressure bonding to increase the contact area between the opposing terminals. Hence, it is possible to achieve a high heat radiation property and high connection reliability.

Also, the anisotropic conductive adhesive according to an embodiment of the technology may be manufactured by evenly mixing the adhesive composition, the conductive particle, and the thermally conductive particle.

### <2. Connection Structure and Manufacturing Method Thereof>

Next, a description is given of a connection structure in which the above-described anisotropic conductive adhesive is used. In the connection structure according to an embodiment of the technology, a terminal of a first electronic component and a terminal of a second electronic component are electrically connected to each other through a conductive particle in which a conductive metal layer is formed on a surface of a resin particle. In the connection structure, a thermally conductive particle whose average particle size is smaller than an average particle size of the conductive particle is captured (held) between the terminal of the first electronic component and the terminal of the second electronic component.

A chip (device) that generates heat, such as a driver IC (Integrated Circuit) and LED (Light Emitting Diode), may be suitable as the electronic components in an embodiment of the technology.

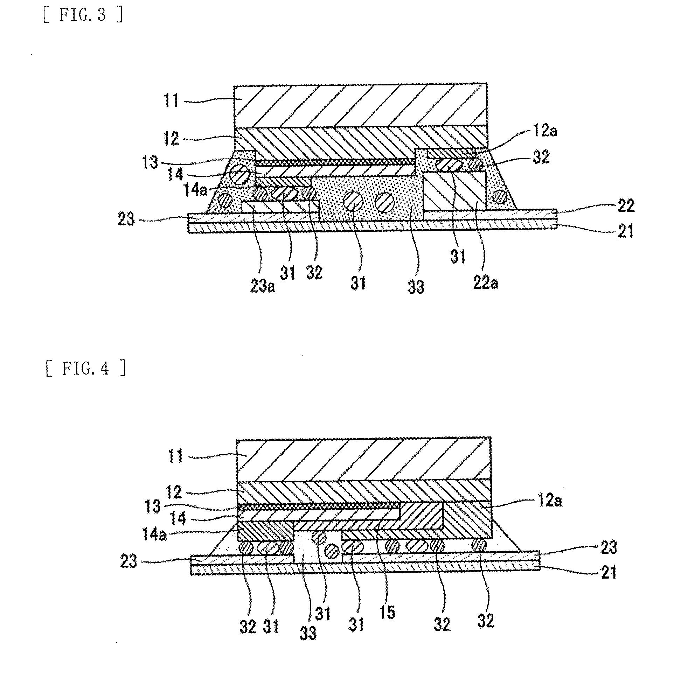

FIG. 3 is a cross-sectional view illustrating a configuration example of an LED package. In the LED package, an LED device (first electronic component) and a substrate (second electronic component) are connected to each other using the above-described anisotropic conductive adhesive in which the conductive particle and the thermally conductive particle whose average particle size is smaller than the average particle size of the conductive particle are dispersed in the adhesive component.

The LED device may have a so-called double heterostructure in which a first conductivity type cladding layer 12 which may be made, for example, of n-GaN, an active layer 13 which may be made, for example, of InₓAl_{y}Ga_{1-x-y}N layer, and a second conductivity type cladding layer 14 which may be made, for example, of p-GaN are provided on a device substrate 11 which may be made, for example, of a sapphire. There are also provided a first conductivity type electrode 12a on a partial region on the first conductivity type cladding layer 12 and a second conductivity type electrode 14a on a partial region on the second conductivity type cladding layer 14. Application of a voltage between the first conductivity type electrode 12a and the second conductivity type electrode 14a of the LED device concentrates carriers on the active layer 13 to cause recombination that results in generation of light.

The substrate includes a first conductivity type circuit pattern 22 and a second conductivity type circuit pattern 23 on a base 21, and has an electrode 22a and an electrode 23a at respective locations corresponding to the first conductivity type electrode 12a and the second conductivity type electrode 14a of the LED device.

In the anisotropic conductive adhesive, the conductive particles 31 and the thermally conductive particles 32 whose average particle size is smaller than the average particle size of the conductive particles 31 are dispersed in a binder 33 as described above.

In the LED package, as illustrated in FIG. 3, the terminals (the electrodes 12a and 14a) of the LED device are electrically connected to the respective terminals (the electrodes 22a and 23a) of the substrate through the conductive particles 31, and the thermally conductive particles 32 are captured between the terminals of the LED device and the terminals of the substrate.

This makes it possible to efficiently transfer heat generated by the active layer 13 of the LED device to the substrate, and thereby to prevent a decrease in light emission efficiency and achieve longer operating life of the LED package. Also, the thermally conductive particle 32 may have an achromatic color of white or gray, making it possible to reflect light from the active layer 13 and thereby to achieve high luminance.

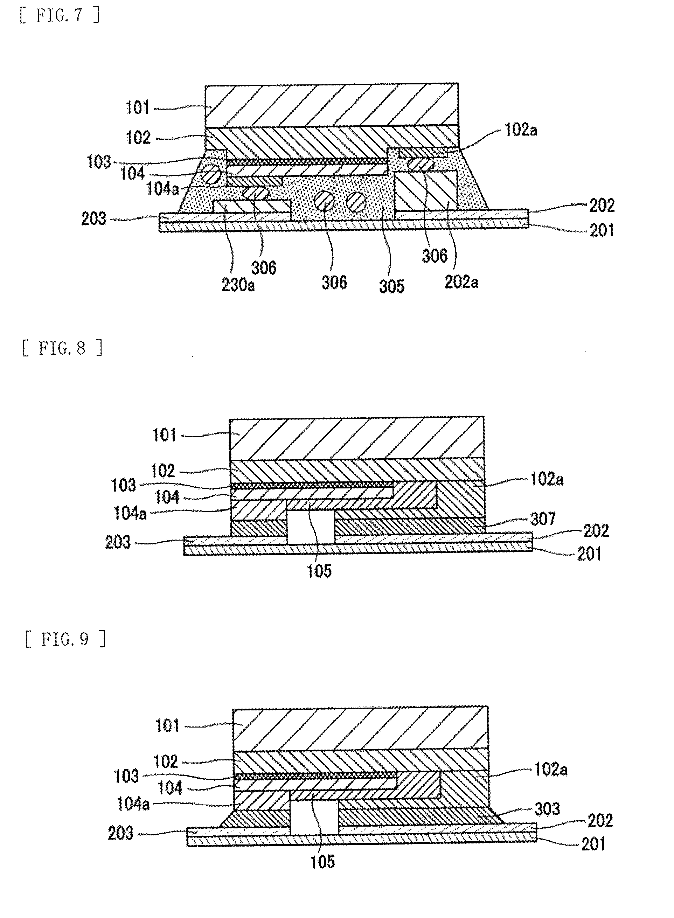

Also, in the LED device for flip-chip mounting, terminals (the electrodes 12a and 14a) of the LED device are designed to be large by means of a passivation 105 (see FIGs. 8 and 9) as illustrated in FIG. 4. Hence, more conductive particles 31 and thermally conductive particles 32 are captured between the terminals (the electrodes 12a and 14a) of the LED device and the terminals (the circuit patterns 22 and 23) of the substrate, thereby making it possible to transfer heat generated by the active layer 13 of the LED device to the substrate further efficiently.

Next, a description is given of a method of manufacturing the connection structure described above. In a method of manufacturing a package according to an embodiment of the technology, the above-described anisotropic conductive adhesive in which the conductive particle and the thermally conductive particle whose average particle size is smaller than the average particle size of the conductive particle are dispersed in the adhesive component is interposed between the terminal of the first electronic component and the terminal of the second electronic component, and thermal pressure bonding is performed on the first electronic component and the second electronic component.

Thereby, it is possible to obtain the connection structure in which the terminal of the first electronic component and the terminal of the second electronic component are electrically connected to each other through the conductive particle and in which the thermally conductive particle is captured between the terminal of the first electronic component and the terminal of the second electronic component.

In the method of manufacturing the connection structure according to an embodiment of the technology, the conductive particle is deformed to be flat by pressing and the thermally conductive particle is crushed upon pressure bonding to increase contact area between the opposing terminals. Hence, it is possible to achieve a high heat radiation property and high connection reliability.

Incidentally, the following are methods in which the anisotropic conductive adhesive and the connection structure each according to an embodiment of the technology described above are unused and respective issues associated therewith.

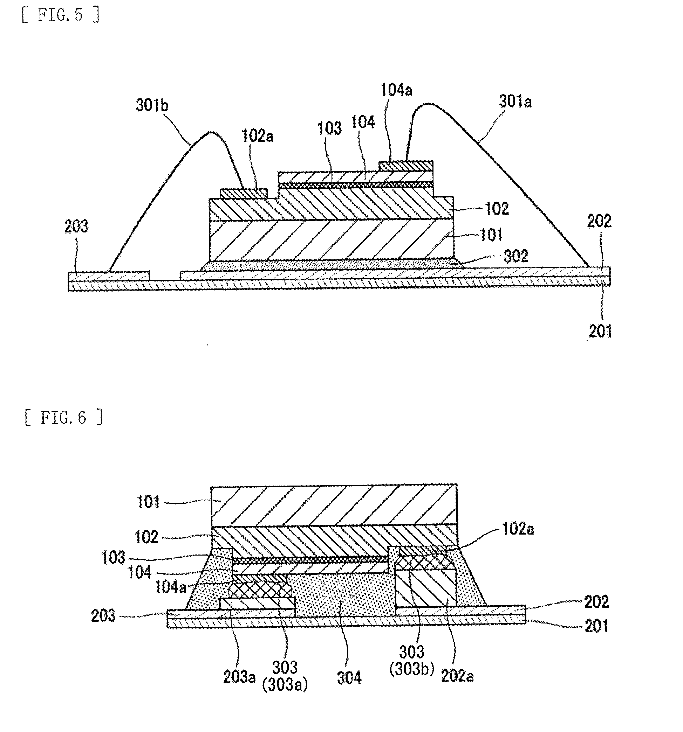

A wire bonding method has been used as a method of mounting an LED device on a substrate. In the wire bonding method, as illustrated in FIG. 5, surfaces of electrodes (a first conductivity type electrode 104a and a second conductivity type electrode 102a) of the LED device are faced upward (face up), and electrical bonding between the LED device and the substrate is performed using wire bonds (WB: Wire Bonding) 301a and 301b. A die bonding material 302 is used for adhesion between the LED device and the substrate.

Such a method of achieving the electrical connection by means of the wire bonds, however, is accompanied by a risk of physical breakage and detachment of the wire bonds from the electrodes (the first conductivity type electrode 104a and the second conductivity type electrode 102a). Hence, a more reliable technology has been demanded. Further, a curing process of the die bonding material 302 is performed based on an oven cure, which requires time for production.

As a method in which no wire bond is used, there is a method as illustrated in FIG. 6 in which the surfaces of the electrodes (the first conductivity type electrode 104a and the second conductivity type electrode 102a) of the LED device are faced toward the substrate (face down, flip-chip), and a conductive paste 303 (303a and 303b) such as typically a silver paste is used for electrical connection between the LED device and the substrate.

The conductive paste 303 (303a and 303b), however, is weak in adhesive force and thus requires reinforcement utilizing a sealing resin 304. Further, a curing process of the sealing resin 304 is performed based on an oven cure, which requires time for production.

As a method in which no conductive paste is used, there is a method as illustrated in FIG. 7 in which the electrode surfaces of the LED device are faced toward the substrate (face down, flip-chip), and an anisotropic conductive adhesive in which conductive particles 306 are dispersed in an insulating adhesive binder 305 is used for electrical connection and adhesion between the LED device and the substrate. The anisotropic conductive adhesive requires a short adhesion process and is thus excellent in production efficiency. Also, the anisotropic conductive adhesive is inexpensive, and is superior in properties such as transparency, adhesiveness, thermal resistance, mechanical strength, and electrical insulation.

Also, an LED device directed to FC mounting has been developed. The LED device for the FC mounting allows for a design in which large electrode area is ensured by means of the passivation 105, thus making it possible to adopt a bump-less mounting. In addition, a light extraction efficiency is improved by providing a reflection film below a light emission layer.

Referring to FIG. 8, gold-tin eutectic bonding has been used as a method of mounting, on a substrate, the LED device for the FC mounting. The gold-tin eutectic bonding is a method in which a chip electrode is formed of an alloy 307 of gold and tin, and a substrate is coated with a flux followed by mounting of a chip and heating thereof to perform eutectic bonding of the substrate and the electrode. Such a solder connection method, however, is accompanied by deterioration in yield due to an adverse effect of a shift of the chip upon heating and unwashed flux on reliability. It also requires a high degree of mounting technology.

Referring to FIG. 9, there is a solder connection method, as a method that uses no gold-tin eutectic, in which a solder paste is used for electrical connection between an electrode surface of an LED device and a substrate. Such a solder connection method, however, may cause short-circuit between p and n electrodes attributed to isotropic conductivity of the paste, thereby deteriorating yield.

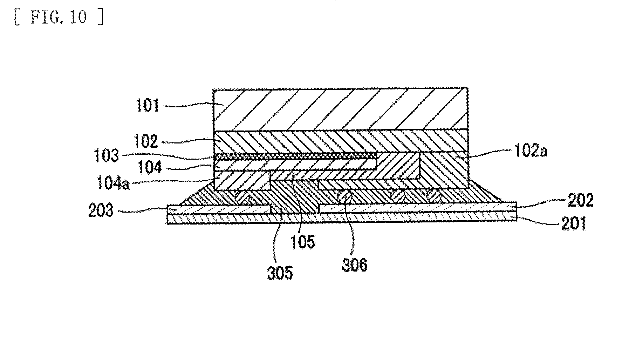

Referring to FIG. 10, there is a method, as a method that uses no solder paste, in which an anisotropic conductive adhesive such as ACF (Anisotropic conductive film) is used for electrical connection and adhesion between an LED device and a substrate. In the anisotropic conductive adhesive, conductive particles are dispersed in an insulating binder as in FIG. 7, and the insulating binder is filled in a region between p and n electrodes. This makes the short circuit difficult to occur, and thus the method is excellent in yield. Also, the method requires a short adhesion process and is hence excellent in production efficiency.

Incidentally, an active layer (junction) 103 of an LED device generates a large amount of heat besides light. A temperature of light emission layer (Tj = junction temperature) of 100 degrees centigrade or higher decreases a light emission efficiency of LED and shortens an operating life of the LED. Hence, a structure is necessary that allows for efficient transfer of heat derived from the active layer 103.

In the WB mounting as illustrated in FIG. 5, the active layer 103 is located on the upper side of the LED device. This prevents the generated heat from transferring to the substrate efficiently, leading to deterioration in a heat radiation property.

Performing the flip-chip mounting as illustrated in FIGs. 6, 8, and 9 allows the active layer 103 to be located on the substrate side, by which the heat is transferred efficiently to a substrate. A heat radiation is performable at high efficiency when a region between the electrodes is bonded using the conductive paste 303 (303a and 303b) as illustrated in FIGs. 6 and 9; however, the connection made by the conductive paste 303 (303a and 303b) is accompanied by deterioration in connection reliability as described above. Also, performing the gold-tin eutectic bonding as illustrated in FIG. 8 is accompanied by the deterioration in connection reliability as likewise described above.

On the other hand, the flip-chip mounting by means of the anisotropic conductive adhesive such as the ACF and ACP (Anisotropic Conductive Paste) as illustrated in FIGs. 7 and 10, without the use of the conductive paste 303 (303a and 303b), allows the active layer 103 to be located near the substrate, by which the heat is transferred efficiently to the substrate. Also, the adhesive force is high, making it possible to achieve high connection reliability.

### EXAMPLES

### <3. Examples>

In the following, a description is given in detail of Examples of the technology. It is to be noted, however, that the technology is by no means limited to these Examples.

### <3.1 Kinds of Thermally Conductive Particles>

In this experiment, anisotropic conductive adhesives (ACP) mixed with respective thermally conductive particles as well as LED packages were fabricated to perform examination on kinds of thermally conductive particles.

Fabrication of the anisotropic conductive adhesives, measurement of thermal conductivities of respective cured products of the anisotropic conductive adhesives, fabrication of the LED packages, evaluation on heat radiation properties of the respective LED packages, evaluation on light characteristics thereof, and evaluation on electrical characteristics thereof were performed as follows.

### [Fabrication of Anisotropic Conductive Adhesives]

10 mass% of conductive particles (available from Sekisui Chemical Co., Ltd. under the product name of AUL705) whose average particle size was 5 µm and in each of which a surface of a resin particle was coated with Au were mixed in an epoxy-curing-based adhesive (a binder containing an epoxy resin (available from Daicel Corporation under the trade name of CEL2021P) and an acid anhydride (MeHHPA, available from New Japan Chemical Co., Ltd. under the trade name of MH700) as major components). This resin composition was mixed with thermally conductive particles to fabricate anisotropic conductive adhesives having a thermally conductive property.

### [Measurement of Thermal Conductivities of Respective Cured Products of Anisotropic Conductive Adhesives]

Each anisotropic conductive adhesive was sandwiched by glass plates, which was then cured under the conditions of 150 degrees centigrade for one hour to obtain a one mm thick cured product. Thereafter, a measurement apparatus utilizing a laser flash method (the xenon flash analyzer LFA447 available from NETZSCH) was used to measure the thermal conductivities of the cured products.

### [Fabrication of LED Packages]

The anisotropic conductive adhesive was used to mount an LED chip (blue LED, Vf = 3.2 V (If = 20 mA)) on an Au electrode substrate. After the Au electrode substrate was coated with the anisotropic conductive adhesive, alignment was performed on the LED chip to mount the LED chip, following which pressure bonding was performed together with heating under the conditions of 200 degrees centigrade, 20 seconds, and 1 Kg/chip. The Au electrode substrate used was a substrate in which Au bumps were formed using a bump bonder and a flattening process was performed thereafter (a glass epoxy substrate, conductor space = 100 µm, Ni/Au plating = 5.0 µm/0.3 µm, gold bump = 15 µm).

### [Evaluation on Heat Radiation Properties]

A transient thermal resistance measuring apparatus (available from CATS Inc.) was used to measure thermal resistance values (°C/W) of the LED packages. The measurement was performed under the condition of If = 200 mA (constant current control).

### [Evaluation on Light Characteristics]

A total luminous flux measuring apparatus utilizing an integrating sphere (LE-2100 available from Otsuka Electronics Co., Ltd.) was used to measure a total luminous flux amount (mlm) of the LED packages. The measurement was performed under the condition of If = 200 mA (constant current control).

### [Evaluation on Electrical Characteristics]

A Vf value in If = 20 mA was measured as an initial Vf value. Also, the LED packages were lit at If = 20 mA for 500 hours under an RH environment of 85% at 85 °C (a high temperature high humidity test) to measure a Vf value in If = 20 mA. To evaluate connection reliability, cases that showed 5% increase from the initial Vf value or greater were evaluated as "Conduction NG" and cases that showed 5% decrease from the initial Vf value or greater were evaluated as "Insulation NG". Otherwise, cases were evaluated as "○". It is to be noted that "○" denotes good, and "NG" means poor.

### [Example 1]

Ag particles (thermal conductivity: 428 W/(m·K)) whose average particle size (D50) was one µm were used as the thermally conductive particles. 5 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.3 W/(m·K). Also, a measurement result on the thermal resistance of the LED package fabricated using such an anisotropic conductive adhesive was 160 °C/W, a measurement result on the total luminous flux amount was 320 mlm, and evaluation results on the connection reliability were determined as ○ in the initial stage and ○ following the high temperature high humidity test.

### [Example 2]

Ag particles (thermal conductivity: 428 W/(m·K)) whose average particle size (D50) was one µm were used as the thermally conductive particles. 20 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.4 W/(m·K). Also, a measurement result on the thermal resistance of the LED package fabricated using such an anisotropic conductive adhesive was 130 °C/W, a measurement result on the total luminous flux amount was 300 mlm, and evaluation results on the connection reliability were determined as ○ in the initial stage and ○ following the high temperature high humidity test.

### [Example 3]

Ag particles (thermal conductivity: 428 W/(m·K)) whose average particle size (D50) was one µm were used as the thermally conductive particles. 40 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.5 W/(m·K). Also, a measurement result on the thermal resistance of the LED package fabricated using such an anisotropic conductive adhesive was 120 °C/W, a measurement result on the total luminous flux amount was 280 mlm, and evaluation results on the connection reliability were determined as ○ in the initial stage and ○ following the high temperature high humidity test.

### [Example 4]

Insulation coated particles whose average particle size (D50) was one µm and in each of which a surface of an Ag particle was coated with 100 nm thick SiO₂ were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.5 W/(m·K). Also, a measurement result on the thermal resistance of the LED package fabricated using such an anisotropic conductive adhesive was 115 °C/W, a measurement result on the total luminous flux amount was 280 mlm, and evaluation results on the connection reliability were determined as ○ in the initial stage and ○ following the high temperature high humidity test.

### [Example 5]

Ag/Pd alloy particles (thermal conductivity: 400 W/(m·K)) whose average particle size (D50) was 1.5 µm were used as the thermally conductive particles. 5 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.4 W/(m·K). Also, a measurement result on the thermal resistance of the LED package fabricated using such an anisotropic conductive adhesive was 135 °C/W, a measurement result on the total luminous flux amount was 300 mlm, and evaluation results on the connection reliability were determined as ○ in the initial stage and ○ following the high temperature high humidity test.

### [Comparative Example 1]

The anisotropic conductive adhesive was fabricated without the mixing of the thermally conductive particles. A measurement result on the thermal conductivity of the cured product of such an anisotropic conductive adhesive was 0.2 W/(m·K). Also, a measurement result on the thermal resistance of the LED package fabricated using such an anisotropic conductive adhesive was 200 °C/W, a measurement result on the total luminous flux amount was 330 mlm, and evaluation results on the connection reliability were determined as ○ in the initial stage and ○ following the high temperature high humidity test.

### [Comparative Example 2]

Ag particles (thermal conductivity: 428 W/(m·K)) whose average particle size (D50) was one µm were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.55 W/(m·K). Also, a measurement result on the thermal resistance of the LED package fabricated using such an anisotropic conductive adhesive was 110 °C/W, a measurement result on the total luminous flux amount was 250 mlm, and evaluation results on the connection reliability were determined as ○ in the initial stage and "Insulation NG" following the high temperature high humidity test.

### [Comparative Example 3]

AlN particles (thermal conductivity: 190 W/(m·K)) whose average particle size (D50) was 1.2 µm were used as the thermally conductive particles. 55 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 1.0 W/(m·K). Also, a measurement result on the thermal resistance of the LED package fabricated using such an anisotropic conductive adhesive was 170 °C/W, a measurement result on the total luminous flux amount was 250 mlm, and evaluation results on the connection reliability were determined as ○ in the initial stage and "Conduction NG" following the high temperature high humidity test.

Table 1 shows the evaluation results of the respective Examples 1 to 5 and Comparative Examples 1 to 3.

**[Table 1]**

| | | | Example 1 | Example 2 | Example 3 | Example 4 | Example 5 | Comparative Example 1 | Comparative Example 2 | Comparative Example 3 |
|---|---|---|---|---|---|---|---|---|---|---|
| Thermally Conductive Particle | Kind | | Ag | Ag | Ag | Ag | Ag/Pd | - | Ag | AlN |
| | Thermal Conductivity (W/(m·K)) | | 428 | 428 | 428 | 428 | 400 | - | 428 | 190 |
| | D50 Particle Size (µm) | | 1 | 1 | 1 | 1 | 1.5 | - | 1 | 12 |
| | Added Amount (Vol%) | | 5 | 20 | 40 | 50 | 20 | - | 50 | 55 |
| | Kind of Surface Coating | | - | - | - | SiO₂ | - | - | - | - |
| | Thickness of Surface Coating (nm) | | - | - | - | 100 | - | - | - | - |
| ACP Cured Product | Thermal Conductivity (W/(m·K)) | | 0.3 | 0.4 | 0.5 | 0.5 | 0.4 | 02 | 0.55 | 1.0 |
| LEDHeat Radiation property | Thermal Resistance (°C/W) | | 160 | 130 | 120 | 115 | 135 | 200 | 110 | 170 |
| LEDLight Characteristic | Total Luminous Flux Amount (mlm) | | 320 | 300 | 280 | 280 | 300 | 330 | 250 | 250 |
| LED Electrical Characteristic | Connection Reliability | Initial | ○ | ○ | ○ | ○ | ○ | ○ | ○ | ○ |
| | | After Test | ○ | ○ | ○ | ○ | ○ | ○ | Insulation | Conduction NG |

In the case where the thermally conductive particles were not added as in the Comparative Example 1, the thermal conductivity of the cured product of the anisotropic conductive adhesive was 0.2 W/(m·K), and the thermal resistance value of the LED package was 200 °C/W. Hence, it was not possible to achieve a superior heat radiation property.

Also, in the case where the 50 volume% of Ag particles where mixed as in the Comparative Example 2, the thermal conductivity of the cured product of the anisotropic conductive adhesive was 0.55 W/(m·K), and the thermal resistance value of the LED package was 110 °C/W; hence, it was possible to achieve a superior heat radiation property as compared with the Comparative Example 1. However, due to a large mixing amount of Ag particles, the Vf value was decreased by 5% or greater from the initial Vf value in the high temperature high humidity test of the LED package.

Further, in the case where the 55 volume% of AlN particles were mixed as in the Comparative Example 3, the thermal conductivity of the cured product of the anisotropic conductive adhesive was 1.0 W/(m·K). However, due to the low thermal conductivity of the AlN, the thermal resistance value of the LED package was 170 °C/W. In addition, due to a large mixing amount of AlN particles as well as a high electrical insulation property of AlN, the Vf value was increased by 5% or greater from the initial Vf value in the high temperature high humidity test of the LED package.

In contrast, in the cases where 5 volume% to 40 volume% of Ag particles were mixed as in the Examples 1 to 3, the thermal conductivities of the respective cured products of the anisotropic conductive adhesives were 0.3 W/(m·K) to 0.5 W/(m·K), and the thermal resistance values of the respective LED packages were 120 °C/W to 160 °C/W; hence, it was possible to achieve a more superior heat radiation property than the Comparative Example 1. It was also possible to achieve high connection reliability in the high temperature high humidity test of the LED packages.

Also, in the case where the insulation coated particles were used in each of which the surface of the Ag particle was coated with SiO₂ as in the Example 4, even the 50 volume% mixing thereof made it possible to achieve high connection reliability in the high temperature high humidity test of the LED package. In addition, the thermal conductivity of the cured product of the anisotropic conductive adhesive was 0.5 W/(m·K), and the thermal resistance value of the LED package was 115 °C/W. Hence, it was possible to achieve a more superior heat radiation property than the Comparative Example 1.

Further, in the case where 20 volume% of Ag/Pt alloy particles were mixed as in the Example 5, the thermal conductivity of the cured product of the anisotropic conductive adhesive was 0.4 W/(m·K), and the thermal resistance value of the LED package was 135 °C/W; hence, it was possible to achieve a more superior heat radiation property than the Comparative Example 1. It was also possible to achieve high connection reliability in the high temperature high humidity test of the LED package.

### <3.2 Thicknesses of Insulating layers of Insulation Coated Particles>

In this experiment, anisotropic conductive adhesives (ACP) in which insulation coated particles, in each of which an insulating layer was formed on a surface of a metal particle, were contained as the thermally conductive particles were fabricated and LED packages were fabricated, to perform examination on thicknesses of insulating layers of the respective insulation coated particles.

Fabrication of the anisotropic conductive adhesives, fabrication of the LED packages, measurement of thermal conductivities of respective cured products of the anisotropic conductive adhesives, evaluation on heat radiation properties of the respective LED packages, and evaluation on light characteristics thereof were performed in similar manners to those in <3.1 Kinds of Thermally Conductive Particles> described previously. Also, fabrication of the insulation coated particles and measurement of withstand voltage of the ACP cured products were performed as follows.

### [Fabrication of Insulation Coated Particles]

Resin powder containing styrene as a major component (an adhesive layer, 0.2 µm in particle size) and Ag metal powder (one µm in particle size) were mixed, following which a film-forming apparatus (Mechanofusion available from Hosokawa Micron Corporation), which forms a film by colliding one powder with another with the use of physical force, was used to obtain a metal in which a white insulating layer of about 100 nm was formed on a surface of the Ag metal powder.

### [Measurement of Withstand Voltage of ACP Cured Products]

A 100 nm thick ACP cured product was applied and formed on a wiring substrate that was patterned in a comb-like shape. Both poles of the comb-like wiring substrate were applied with a voltage of up to 500 V, and a voltage at which a current of 0.5 mA was flowed was determined as a withstand voltage. The withstand voltage in an inter-wiring space of 25 µm and the withstand voltage in an inter-wiring space of 100 µm were measured.

### [Example 6]

Insulation coated particles whose average particle size (D50) was one µm and in each of which a surface of an Ag particle was coated with a 20 nm thick styrene resin were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.5 W/(m·K). A test result on the withstand voltage in the inter-wiring space of 25 µm was 150 V, and a test result on the withstand voltage in the inter-wiring space of 100 µm exceeded 500 V. Also, a measurement result on the thermal resistance of the LED package fabricated using such an anisotropic conductive adhesive was 130 °C/W, and a measurement result on the total luminous flux amount was 300 mlm.

### [Example 7]

Insulation coated particles whose average particle size (D50) was one µm and in each of which a surface of an Ag particle was coated with a 100 nm thick styrene resin were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.4 W/(m·K). A test result on the withstand voltage in the inter-wiring space of 25 µm was 210 V, and a test result on the withstand voltage in the inter-wiring space of 100 µm exceeded 500 V. Also, a measurement result on the thermal resistance of the LED package fabricated using such an anisotropic conductive adhesive was 120 °C/W, and a measurement result on the total luminous flux amount was 280 mlm.

### [Example 8]

Insulation coated particles whose average particle size (D50) was one µm and in each of which a surface of an Ag particle was coated with an 800 nm thick styrene resin were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.5 W/(m·K). A test result on the withstand voltage in the inter-wiring space of 25 µm was 450 V, and a test result on the withstand voltage in the inter-wiring space of 100 µm exceeded 500 V. Also, a measurement result on the thermal resistance of the LED package fabricated using such an anisotropic conductive adhesive was 115 °C/W, and a measurement result on the total luminous flux amount was 280 mlm.

### [Example 9]

Insulation coated particles whose average particle size (D50) was one µm and in each of which a surface of an Ag particle was coated with a 100 nm thick SiO₂ were used as the thermally conductive particles. As in the Example 4, 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.5 W/(m·K). A test result on the withstand voltage in the inter-wiring space of 25 µm was 230 V, and a test result on the withstand voltage in the inter-wiring space of 100 µm exceeded 500 V. Also, a measurement result on the thermal resistance of the LED package fabricated using such an anisotropic conductive adhesive was 115 °C/W, and a measurement result on the total luminous flux amount was 280 mlm.

### [Example 10]

Insulation coated particles whose average particle size (D50) was 1.5 µm and in each of which a surface of an Ag/Pd alloy particle was coated with a 100 nm thick styrene resin were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.4 W/(m·K). A test result on the withstand voltage in the inter-wiring space of 25 µm was 210 V, and a test result on the withstand voltage in the inter-wiring space of 100 µm exceeded 500 V. Also, a measurement result on the thermal resistance of the LED package fabricated using such an anisotropic conductive adhesive was 135 °C/W, and a measurement result on the total luminous flux amount was 280 mlm.

### [Comparative Example 4]

The anisotropic conductive adhesive was fabricated without the mixing of the thermally conductive particles. As in the Comparative Example 1, a measurement result on the thermal conductivity of the cured product of such an anisotropic conductive adhesive was 0.2 W/(m·K). A test result on the withstand voltage in the inter-wiring space of 25 µm was 200 V, and a test result on the withstand voltage in the inter-wiring space of 100 µm exceeded 500 V. Also, a measurement result on the thermal resistance of the LED package fabricated using such an anisotropic conductive adhesive was 200 °C/W, and a measurement result on the total luminous flux amount was 330 mlm.

### [Comparative Example 5]

Ag particles (thermal conductivity: 428 W/(m·K)) whose average particle size (D50) was one µm were used as the thermally conductive particles. 50 volume% of such thermally conductive particles were mixed in the resin composition described above to fabricate the anisotropic conductive adhesive having a thermally conductive property. As in the Comparative Example 2, a measurement result on the thermal conductivity of the cured product of such an anisotropic conductive adhesive was 0.55 W/(m·K). A test result on the withstand voltage in the inter-wiring space of 25 µm was 100 V, and a test result on the withstand voltage in the inter-wiring space of 100 µm was 200 V. Also, a measurement result on the thermal resistance of the LED package fabricated using such an anisotropic conductive adhesive was 110 °C/W, and a measurement result on the total luminous flux amount was 250 mlm.

### [Comparative Example 6]

Insulation coated particles whose average particle size (D50) was one µm and in each of which a surface of an Ag particle was coated with a 1100 nm thick styrene resin were used as the thermally conductive particles. 50 volume% of such thermally conductive particles were mixed in the resin composition described above to fabricate the anisotropic conductive adhesive having a thermally conductive property. A measurement result on the thermal conductivity of the cured product of such an anisotropic conductive adhesive was 0.4 W/(m·K). A test result on the withstand voltage in the inter-wiring space of 25 µm was 300 V, and a test result on the withstand voltage in the inter-wiring space of 100 µm exceeded 500 V. Also, a measurement result on the thermal resistance of the LED package fabricated using such an anisotropic conductive adhesive was 190 °C/W, and a measurement result on the total luminous flux amount was 300 mlm.

Table 2 shows the evaluation results of the respective Examples 6 to 10 and Comparative Examples 4 to 6.

**[Table 2]**

| | | | Example 6 | Example 7 | Example 8 | Example 9 | Example 10 | Comparative Example 4 | Comparative Example 5 | Comparative Example 6 |
|---|---|---|---|---|---|---|---|---|---|---|
| Thermally Conductive Particle | Kind | | Ag | Ag | Ag | Ag | Ag/Pd | - | Ag | Ag |
| | Thermal Conductivity (W/(m·K)) | | 428 | 428 | 428 | 428 | 400 | - | 428 | 428 |
| | D50 Particle Size (µm) | | 1 | 1 | 1 | 1 | 1.5 | - | 1 | 1 |
| | Added Amount (Vol%) | | 50 | 50 | 50 | 50 | 50 | - | 50 | 50 |
| | Kind of Surface Coating | | Styrene | Styrene | Styrene | SiO₂ | Styrene | - | - | Styrene |
| | Thickness of Surface Coating (nm) | | 20 | 100 | 800 | 100 | 100 | - | - | 1100 |
| ACP Cured Product | Thermal Conductivity (W/(m·K)) | | 0.5 | 0.4 | 0.5 | 0.5 | 0.4 | 0.2 | 0.55 | 0.4 |
| | Withstand Voltage | Inter-wiring Space: 25 µm (V) | 150 | 210 | 450 | 230 | 210 | 200 | 100 | 300 |
| | | Inter-wiring Space: 100 µm (V) | 500< | 500< | 500< | 500< | 500< | 500< | 200 | 500< |
| LED Heat Radiation Property | Thermal Resistance (°C/W) | | 130 | 120 | 115 | 115 | 135 | 200 | 110 | 190 |
| LED Light Characteristic | Total Luminous Flux Amount (mlm) | | 300 | 280 | 280 | 280 | 300 | 330 | 250 | 300 |

In the case where the thermally conductive particles were not added as in the Comparative Example 4, the thermal conductivity of the cured product of the anisotropic conductive adhesive was 0.2 W/(m·K) and the thermal resistance value of the LED package was 200 °C/W as in the Comparative Example 1. Hence, it was not possible to achieve a superior heat radiation property. As for the withstand voltage, the withstand voltage was 200 V in the inter-wiring space of the cured product of the anisotropic conductive adhesive of 25 µm, and exceeded 500 V in the inter-wiring space of 100 µm. Hence, it was possible to achieve a stable insulation property.

Also, in the case where the 50 volume% of Ag particles where mixed as in the Comparative Example 5, the thermal conductivity of the cured product of the anisotropic conductive adhesive was 0.55 W/(m·K) and the thermal resistance value of the LED package was 110 °C/W as in the Comparative Example 2; hence, it was possible to achieve a superior heat radiation property as compared with the Comparative Example 1. However, due to a large mixing amount of Ag particles, the withstand voltage was 100 V in the inter-wiring space of the cured product of the anisotropic conductive adhesive of 25 µm, and was 200 V in the inter-wiring space of 100 µm. Hence, it was not possible to achieve a stable insulation property.

Further, in the case where the insulation coated particles in each of which the surface of the Ag particle was coated with the 1100 nm thick styrene resin were used as in the Comparative Example 6, the thermal conductivity of the cured product of the anisotropic conductive adhesive was 0.4 W/(m·K). However, the thermal resistance value of the LED package was 190 °C/W; hence, it was possible to obtain a value only slightly lower than that of the Comparative Example 4. This is due to occurrence of inhibition of thermal conduction attributed to the thick insulating layer of the styrene resin. As for the withstand voltage, the withstand voltage was 300 V in the inter-wiring space of the cured product of the anisotropic conductive adhesive of 25 µm, and exceeded 500 V in the inter-wiring space of 100 µm. Hence, it was possible to achieve a stable insulation property.

In contrast, in the cases where thicknesses of the respective insulating layers of the styrene resins were 20 nm to 800 nm as in the Examples 6 to 8, the thermal conductivities of the respective cured products of the anisotropic conductive adhesives were 0.4 W/(m·K) to 0.5 W/(m·K), and the thermal resistance values of the respective LED packages were 115 °C/W to 130 °C/W; hence, it was possible to achieve a more superior heat radiation property than the Comparative Example 1. Also, the withstand voltages were 210 V to 450 V in the inter-wiring space of the cured products of the anisotropic conductive adhesives of 25 µm, and each exceeded 500 V in the inter-wiring space of 100 µm. Hence, it was possible to achieve stable insulation properties.

Also, in the case where the insulation coated particles were used in each of which the surface of the Ag particle was coated with SiO₂ as in the Example 9, the thermal conductivity of the cured product of the anisotropic conductive adhesive was 0.5 W/(m·K) and the thermal resistance value of the LED package was 115 °C/W as in the Example 4; hence, it was possible to achieve a more superior heat radiation property than the Comparative Example 1. Also, the withstand voltage was 230 V in the inter-wiring space of the cured product of the anisotropic conductive adhesive of 25 µm, and exceeded 500 V in the inter-wiring space of 100 µm. Hence, it was possible to achieve a stable insulation property.

Further, in the case where the insulation coated particles were used in which the Ag/Pd alloy particles were coated with the styrene resin as in the Example 10, the thermal conductivity of the cured product of the anisotropic conductive adhesive was 0.4 W/(m·K) and the thermal resistance value of the LED package was 135 °C/W; hence, it was possible to achieve a more superior heat radiation property than the Comparative Example 1. Also, the withstand voltage was 210 V in the inter-wiring space of the cured product of the anisotropic conductive adhesive of 25 µm, and exceeded 500 V in the inter-wiring space of 100 µm. Hence, it was possible to achieve a stable insulation property.

It is also possible for the technology to adopt the following configurations.
(1) An anisotropic conductive adhesive, including:
   a conductive particle including a resin particle and a conductive metal layer that is formed on a surface of the resin particle;
   a thermally conductive particle being a metal particle or an insulation coated particle, the metal particle having an average particle size that is smaller than an average particle size of the conductive particle, and the insulation coated particle having an average particle size that is smaller than the average particle size of the conductive particle and including a metal particle and an insulating layer that is formed on a surface of the metal particle; and
   an adhesive component in which the conductive particle and the thermally conductive particle are dispersed.
(2) The anisotropic conductive adhesive according to (1), wherein the metal particle has a thermal conductivity that is equal to or higher than about 200 W/(m·K), and the metal particle of the insulation coated particle has a thermal conductivity that is equal to or higher than about 200 W/(m·K).
(3) The anisotropic conductive adhesive according to (1) or (2), wherein the metal particle includes silver or includes an alloy that contains silver as a major component, and the metal particle of the insulation coated particle includes silver or includes an alloy that contains silver as a major component.
(4) The anisotropic conductive adhesive according to any one of (1) to (3), wherein a content of the metal particle is in a range from about 5 percent by volume to about 40 percent by volume both inclusive.
(5) The anisotropic conductive adhesive according to any one of (1) to (3), wherein the insulating layer has a thickness in a range from about 20 nanometers to about 1000 nanometers both inclusive.
(6) The anisotropic conductive adhesive according to any one of (1) to (3), wherein the insulating layer includes one of a resin and an inorganic material.
(7) The anisotropic conductive adhesive according to (6), wherein a content of the insulation coated particle is in a range from about 5 percent by volume to about 50 percent by volume both inclusive.
(8) The anisotropic conductive adhesive according to any one of (1) to (7), wherein the average particle size of the thermally conductive particle is about 5 percent to about 80 percent of the average particle size of the conductive particle.
(9) The anisotropic conductive adhesive according to any one of (1) to (8), wherein the thermally conductive particle has an achromatic color of one of white and gray.
(10) A connection structure, including:
   a terminal of a first electronic component;
   a terminal of a second electronic component;
   a conductive particle provided between the terminal of the first electronic component and the terminal of the second electronic component and electrically connecting the terminal of the first electronic component with the terminal of the second electronic component, the conductive particle including a resin particle and a conductive metal layer that is formed on a surface of the resin particle; and
   a thermally conductive particle provided and held between the terminal of the first electronic component and the terminal of the second electronic component, the thermally conductive particle being a metal particle or an insulation coated particle, the metal particle having an average particle size that is smaller than an average particle size of the conductive particle, and the insulation coated particle having an average particle size that is smaller than the average particle size of the conductive particle and including a metal particle and an insulating layer that is formed on a surface of the metal particle.
(11) The connection structure according to (10), wherein the first electronic component includes a light-emitting diode device, and the second electronic component includes a substrate.
(12) The connection structure according to (10), wherein the thermally conductive particle has an achromatic color of one of white and gray.

This application claims the priority benefit of Japanese Patent Application No. 2012-210223 filed in the Japan Patent Office on September 24, 2012, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

## Claims

1. An anisotropic conductive adhesive, comprising:
a conductive particle including a resin particle and a conductive metal layer that is formed on a surface of the resin particle;
a thermally conductive particle being a metal particle or an insulation coated particle, the metal particle having an average particle size that is smaller than an average particle size of the conductive particle, and the insulation coated particle having an average particle size that is smaller than the average particle size of the conductive particle and including a metal particle and an insulating layer that is formed on a surface of the metal particle; and
an adhesive component in which the conductive particle and the thermally conductive particle are dispersed.

2. The anisotropic conductive adhesive according to claim 1, wherein the metal particle has a thermal conductivity that is equal to or higher than about 200 W/(m·K), and the metal particle of the insulation coated particle has a thermal conductivity that is equal to or higher than about 200 W/(m·K).

3. The anisotropic conductive adhesive according to claim 1 or 2, wherein the metal particle includes silver or includes an alloy that contains silver as a major component, and the metal particle of the insulation coated particle includes silver or includes an alloy that contains silver as a major component.

4. The anisotropic conductive adhesive according to any one of claims 1 to 3, wherein a content of the metal particle is in a range from about 5 percent by volume to about 40 percent by volume both inclusive.

5. The anisotropic conductive adhesive according to any one of claims 1 to 3, wherein the insulating layer has a thickness in a range from about 20 nanometers to about 1000 nanometers both inclusive.

6. The anisotropic conductive adhesive according to any one of claims 1 to 3, wherein the insulating layer includes one of a resin and an inorganic material.

7. The anisotropic conductive adhesive according to claim 6, wherein a content of the insulation coated particle is in a range from about 5 percent by volume to about 50 percent by volume both inclusive.

8. The anisotropic conductive adhesive according to any one of claims 1 to 7, wherein the average particle size of the thermally conductive particle is about 5 percent to about 80 percent of the average particle size of the conductive particle.

9. The anisotropic conductive adhesive according to any one of claims 1 to 8, wherein the thermally conductive particle has an achromatic color of one of white and gray.

10. A connection structure, comprising:
a terminal of a first electronic component;
a terminal of a second electronic component;
a conductive particle provided between the terminal of the first electronic component and the terminal of the second electronic component and electrically connecting the terminal of the first electronic component with the terminal of the second electronic component, the conductive particle including a resin particle and a conductive metal layer that is formed on a surface of the resin particle; and
a thermally conductive particle provided and held between the terminal of the first electronic component and the terminal of the second electronic component, the thermally conductive particle being a metal particle or an insulation coated particle, the metal particle having an average particle size that is smaller than an average particle size of the conductive particle, and the insulation coated particle having an average particle size that is smaller than the average particle size of the conductive particle and including a metal particle and an insulating layer that is formed on a surface of the metal particle.

11. The connection structure according to claim 10, wherein the first electronic component includes a light-emitting diode device, and the second electronic component includes a substrate.

12. The connection structure according to claim 10, wherein the thermally conductive particle has an achromatic color of one of white and gray.
